Europäisches Patentamt

European Patent Office

Office européen des brevets

(11) Publication number: **0 388 953**
**A2**

# (12) EUROPEAN PATENT APPLICATION

(21) Application number: **90105436.1**

(22) Date of filing: **22.03.90**

(51) Int. Cl.⁵: **H02K 11/00, H02K 9/00**

(30) Priority: **22.03.89 JP 32201/89 U**
**22.03.89 JP 32205/89 U**

(43) Date of publication of application:
**26.09.90 Bulletin 90/39**

(84) Designated Contracting States:
**DE FR GB**

(71) Applicant: **MITSUBA ELECTRIC MFG. CO., LTD.**
**1-2681 Hirosawa-cho**
**Kiryu-shi Gunma-ken(JP)**

(72) Inventor: **Takahashi, Hideyuki**
**150-296, Oaza-Narizuka, Ota-shi,**
**Gunma-ken(JP)**
Inventor: **Furuuchi, Hideki**
**1-1379-1, Imaizumi-cho, Isesaki-shi**
**Gunma-ken(JP)**

(74) Representative: **Reinhard, Skuhra, Weise**
**Friedrichstrasse 31**
**D-8000 München 40(DE)**

(54) **Vehicle generator with rectifying unit.**

(57) In a rectifier structure for a vehicle generator, the rectifying unit has a pair of laminated metal cooling plates, and diodes, disposed on these plates on the same side with respect to a direction of rotor axis, for positive and negative electrodes. The arrangement of the rectifier structure is that cooling fins are shaped on an inner and/or outer circumference of one of two cooling plates, and the diodes on the inner cooling plate deviate from those on the outer cooling plate, these diodes being disposed in the same position in a radial direction but turned in a peripheral direction.

*FIG. 3*

## VEHICLE GENERATOR WITH RECTIFYING UNIT

The present invention relates to a structure of a rectifier in a vehicle generator mounted on vehicles such as a private motorcar, a bus, a truck and so on.

This kind of generator for use with a vehicle typically incorporates a rectifying unit for rectifying an alternating current into a direct current. Some of the rectifying units comprise a pair of laminated metal cooling plates for positive and negative electrodes, the metal plates each assuming a flat horseshoe-like configuration and being insulated from each other; and diodes attached to the metal plates. This type of rectifying unit, however, has to be cooled by efficiently radiating the heat generated during its operation. The heat radiation of the cooling plates formed in the flat horseshoe-like shape has hitherto been simply effected via ventilating holes or perforations arranged in the cooling plates, which inevitably causes a drop in efficiency of the heat radiation. For this reason, the cooling plates have to be enlarged to improve the heat radiating efficiency, which is an obstacle to designing a generator of small dimensions and reduced weight. This is the present situation.

It is a primary object of the present invention to provide a rectifying unit in a vehicle generator having a structure eliminating the defects inherent in the prior art.

To this end, according to one aspect of the present invention, a rectifying unit in a vehicle generator comprises a pair of metal cooling plates, each having a flat hoofed or horseshoe-like configuration, being insulated from each other and being connected to a positive or negative electrode, respectively, and diodes used for the positive electrode and disposed substantially on the same radius as that of the cooling plate for the positive electrode; and diodes used for the negative electrode and disposed substantially on the same radius as that of the cooling plate for the negative electrode, the pair of cooling plates being laminated such that the diodes provided on the plates are located on the same side with respect to the direction of the rotor axis, wherein cooling fins are formed at least on the outer circumference of one cooling plate of said pair of cooling plates being positioned outwardly of the rotor axis and wherein said diodes being attached onto the other cooling plate which is positioned inwardly of the rotor axis are inclined toward the outer periphery therof with respect to the diodes attached onto the outer cooling plate.

Based on this construction, a rectifying unit is arranged such that the cooling fins are shaped at least on the outer circumference of one cooling plate of a pair of cooling plates which is positioned outwardly of the rotor axis, diodes which are arranged on the other cooling plate positioned inwardly of the rotor axis are provided closer to the outer periphery thereof than the diodes attached to the outer cooling plate, wherein an outside diameter of the outer cooling plate is smaller than that of the inner cooling plate.

According to another aspect of the invention, in a rectifying unit in a vehicle generator there are provided: a pair of metal cooling plates, each assuming a flat hoofed or horseshoe-like configuration and being insulated from each other, each plate being connected to a positive or negative electrode, respectiyly, diodes used for the positive electrode and disposed substantially on the same radius as that of the cooling plate for the positive electrode; and diodes used for the negative electrode and disposed substantially on the same radius as that of the cooling plate for the negative electrode, the pair of cooling plates being laminated so that the diodes provided on the plates are located on the same side with respect to a rotor axis. A rectifying device comprising cooling fins being shaped on any one of inner and outer circumferences of one cooling plate of the pair of cooling plates which is positioned outwardly of the rotor axis, and the diodes fixed to the cooling plates, respectively, are disposed in the same positions in a radial direction but offset with respect to each other in a peripheral direction.

Based on this construction, a rectifying device is arranged such that the cooling fins are shaped on the inner and outer circumferences of one cooling plate of the pair of cooling plates which is positioned outwardly of the rotor axis, and the diodes attached to the cooling plates, respectively, are disposed in the same position in the radial direction but they are offset in peripheral direction.

Other objects and advantages of the present invention will become apparent from the following discussion in conjunction with the accompanying drawings.

The drawings show embodiments of a structure of a rectifying unit in a vehicle generator according to the present invention.

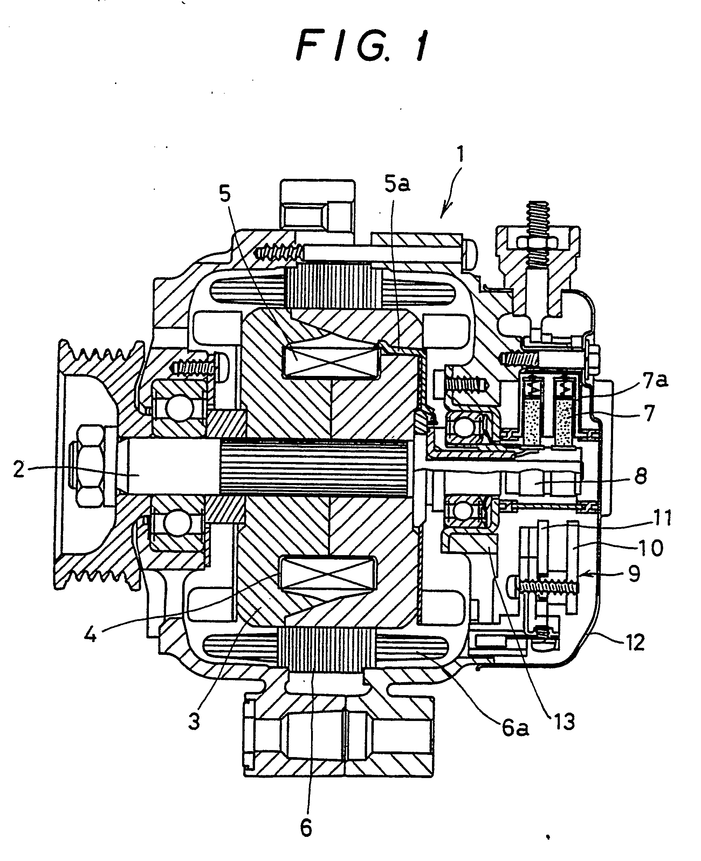

Fig. 1 is a sectional view illustrating a generator for a vehicle;

Figs. 2A and 2B are plan views each depicting a cooling plate;

Fig. 3 is a diagram explaining cooling action;

Figs. 4 to 10 are diagrams for explaining cooling action in embodiments 2 to 8;

Figs. 11A and 11B are plan views each depicting a cooling plate in an embodiment 9;

Fig. 12 is an explanatory diagram for the cooling action;

Figs. 13 to 19 are explanatory diagrams for the cooling action in embodiments 10 through 16;

Figs. 20A, 20B, 20C are plan views of cooling plates in an embodiment 17, Fig. 20C shows laminated cooling plates;

Fig. 21 is an explanatory diagram of the cooling action thereof;

Figs. 22 to 28 are diagrams for explaining the cooling action in embodiments 18 through 24;

Figs. 29A and 29B are plan views showing cooling plates in an embodiment 25;

Fig. 30 is an explanatory diagram of the cooling action thereof;

Figs. 31 to 33 are explanatory diagrams of the cooling action in embodiments 26 through 28; and

Figs. 34 and 35 are plan views illustrating round-arc-shaped cooling plates having slit-like cooling fins.

One embodiment of the present invention will hereinafter be described with reference to the accompanying drawings. In the drawings numeral 1 represents a generator for use in a vehicle, the generator 1 being constructed of: a rounded-circular rotor core 3 in press fit mounted on a rotor shaft 2; a rotor coil 5 wound on a coil bobbin 4 incorporated in the rotor core 3; a stator coil 6 wound on a stator core 6a; a brush elastically accommodated in a brush holder 7a; a slip ring 8 on which the brush 7 slides; and a rectifier 9 for rectifying an alternating current into a direct current. This construction corresponds to the prior art.

The rectifier 9 comprises two sheets of laminated meatal cooling plates 10 and 11, each assuming a flat hoofed or horseshoe-like configuration and being insulated from each other and being connected to a positive or negative electrode, respectively. The rectifier 9 is accommodated in a space formed between a rear cover 12 and an end bracket 13; the cooling plate 10 for the negative electrode is arranged on the side of the rear cover 12 (outwardly in the direction of the rotor axis); and the cooling plate 11 for the positive electrode is arranged on the side of the end bracket 13 (inwardly in the direction of the rotor axis). A plurality of diodes 15 for the negative electrode is disposed substantially on the same radius as that of the outer cooling plate (for the negative electrode) 10, while a plurality of diodes 16 for the positive electrode is disposed substantially on the same radius as that of the inner cooling plate (for the positive electrode) 11. These diodes 15 and 16 are located on the same side with respect to the direction of the rotor axis.

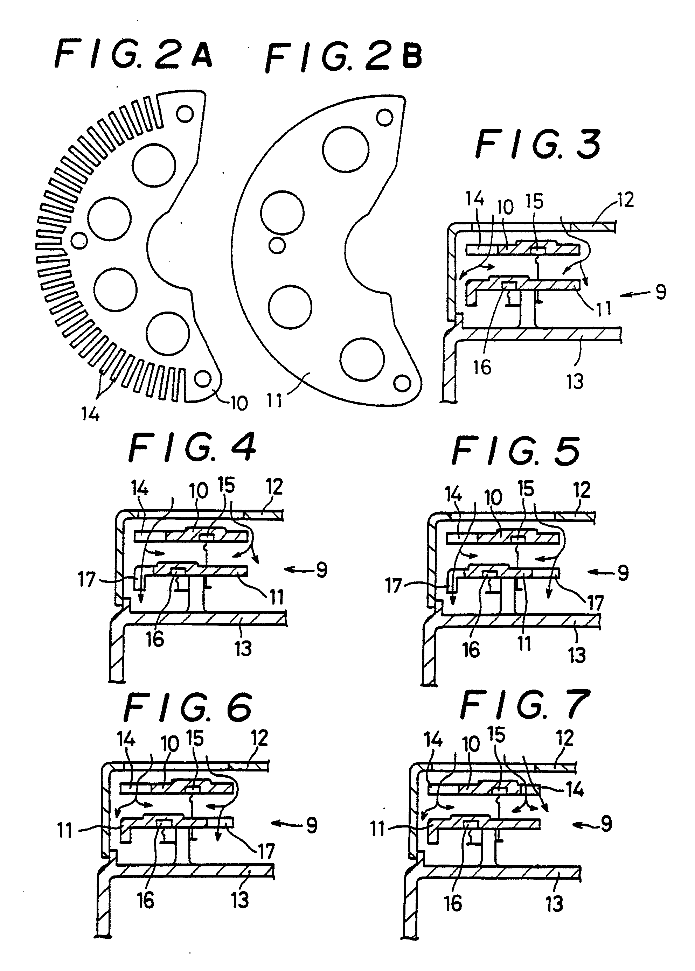

Shaped on an outer circumference of the outer cooling plate 10 are cooling fins 14 protruding to assume a saw-toothed configuration in an outwardly directed radial direction (Fig. 2a). The diodes 15 are fitted on plate 10 while being turned towards the rotor axis. On the other hand, an outer circumferen ce of the inner cooling plate 11 is positioned in close proximity to tip parts of the cooling fins 14 and its edge is bent toward the end bracket 13. The diodes 16 are fixed to the inner cooling plate 11 such that the diodes 16 are disposed in positions substantially being turned away from the cooling fins 14 and being positioned closer to the outer periphery than the diodes 15 of the outer cooling plate 10.

In accordance with the embodiment of the present invention having the construction given above, cooling air blown in from the rear cover simultaneously with an actuation of the generator serves to cool down the cooling plates 10 and 11. The outer cooling plate 10 undergoing intensive cooling action of the cooling fins 14 is, as a matter of course, promoted to be cooled off at a high efficiency. Besides, the cooling air passing through the cooling fins 14 is caught efficiently by the inner cooling plate 11, and it follows that the air flows between the cooling plates 10 and 11 such that they are in turn cooled down with a still higher efficiency.

On the other hand, the inner cooling plate 11 receives the cooling action given by the cooling air caught at the high efficiency after running through the cooling fins 14. The diodes 16 are fitted to surface portions of the inner cooling plate 11, towards which the cooling air passing through the cooling fins 14 is blown. In addition, the fitting positions of the diodes 16 deviate toward the outer periphery from the positions in which the diodes 15 being an exothermic source are provided on the outer cooling plate 10. The described arrangement provides a combination such as to exhibit a remarkable improvement of the cooling efficiency, thereby making it possible to construct the rectifying unit 9 which, though small both in size and in weight, has excellent cooling characteristics, without having a larger size than that of the prior art, and cooling plates securing a cooling area.

When comparing an equal-sized generator of the prior art with a generator according to the invention mounted on a private motorcar under the same conditions, such generator showed that the temperature increase during flowing of recitified current can be reduced by more than 10°C to 15°C than in the prior art generator. This difference in temperature is equivalent to a temperature increase for approximately 10 ampères of the rectified current. Hence follows that the generator of the invention, though having the same size, has a higher performance and output than the conventional one. This implies that the present invention provides a higher efficiency.

In accordance with embodiments 2 through 4 illustrated in figs. 4 to 6, cooling fins 17 may be formed on the inner cooling plate 11. This arrangement promotes a further enhanced cooling action of the inner cooling plate 11.

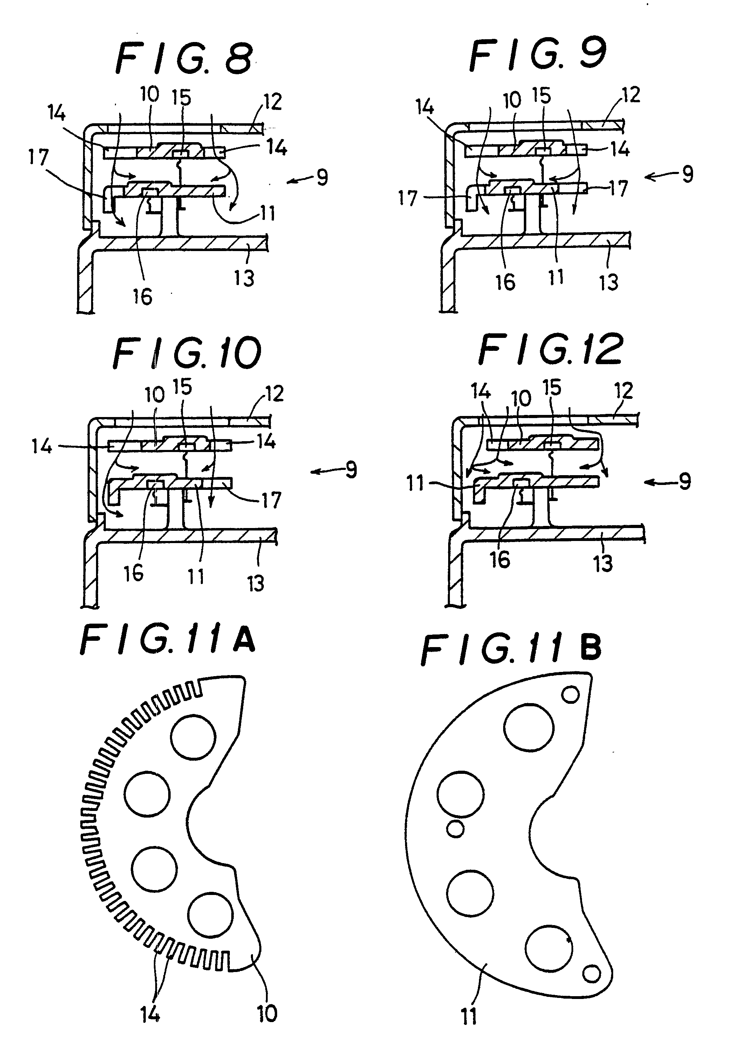

According to the present invention, as shown in embodiments 5 through 8 of figs. 7 to 10, the cooling fins 14 may be shaped not only on the outer circumference of the outer cooling plate 10 but also on the inner circumference thereof. This arrangement is convenient, because an intensive and efficient cooling action of the cooling air can be expected on the side of the inner circumference.

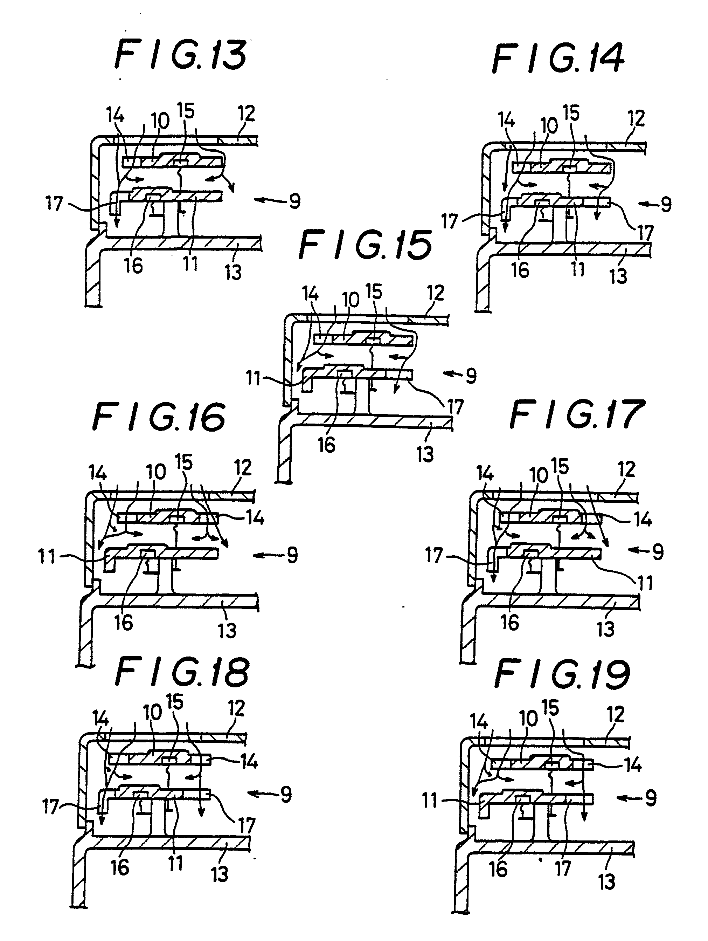

In the present invention, as shown in an embodiment 9 illustrated in figs. 11 and 12, the outside diameter of the outer cooling plate 10 is smaller than that of the inner cooling plate 11, whereby the outer circumference of the inner cooling plate 11 can be observed directly from a rear cover 11. By virtue of this arrangement, a more excellent cooling effect can be achieved with respect to the inner cooling plate 11 as well as to the outer cooling plate 10. Thus, a convenient condition is developed.

Of course, in embodiments 10 to 16 of figs. 13 to 19, the cooling fins 17 may be formed on the inner cooling plate 11; or alternatively the cooling fins 14 may be provided on the inner and outer circumference of the outer cooling plate 10.

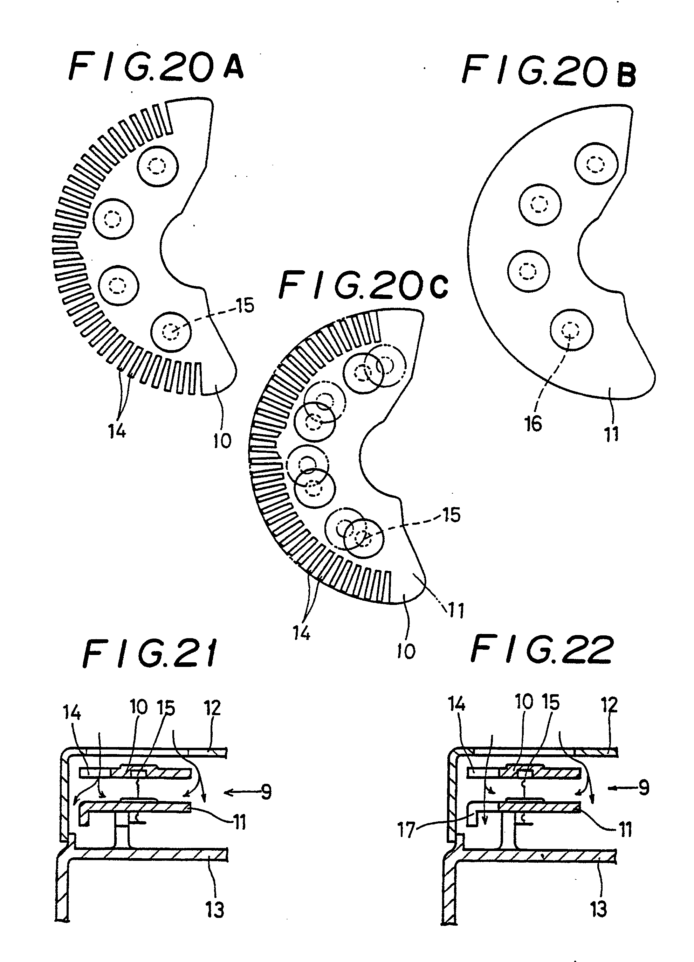

According to the present invention, as shown in an embodiment 17 of figs. 20 and 21, the diodes 15 of the outer cooling plate 10 and the diodes 16 of the inner cooling plate 11 may be disposed in such positions as to be turned in the peripheral direction. More specifically, the outer circumference of the outer cooling plate 10 is formed with the saw-toothed cooling fins 14 protruding in the radial direction of plate 10, while the diodes 15 are fitted in substantially central positions in the radial direction of the outer cooling plate 10. On the other hand, the outer circumference of the inner cooling plate 11 is located in close proximity to the tip parts of the cooling fins 14 and is bent toward an end bracket 13. The diodes 16 of the inner cooling plate 11 are disposed in the same positions in the raidal direction as those of the diodes 15 but are fitted while being turned therefrom in the peripheral direction. Based on this arrangement, the diodes 15 and 16 which serve as an exothermic source are disposed while being turned from each other in the peripheral direction, thereby performing the cooling operation at a high efficiency.

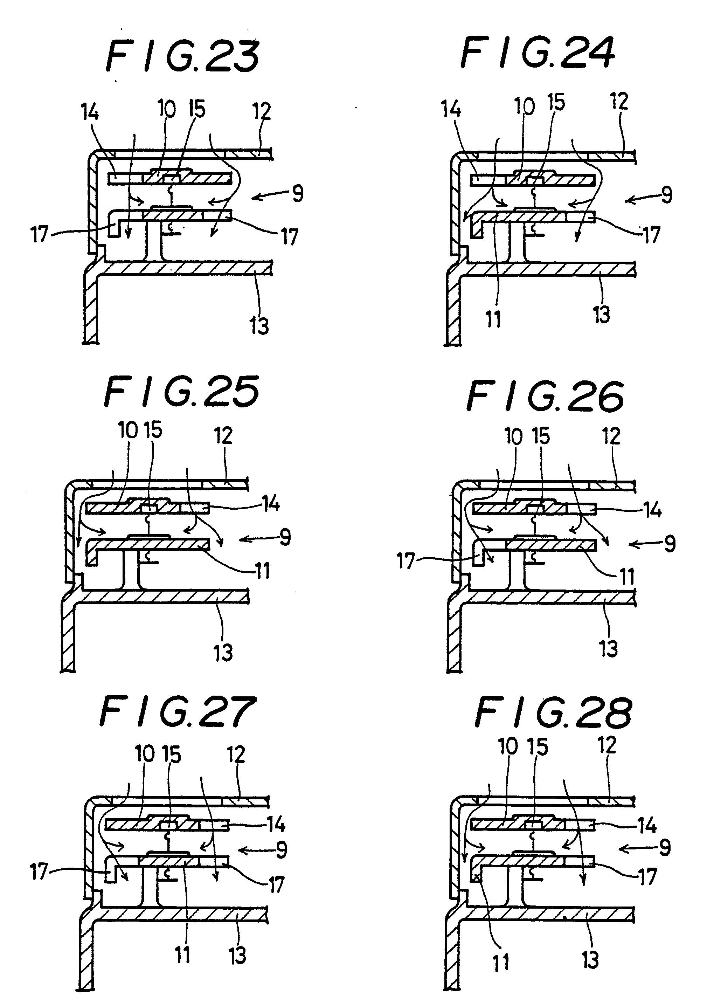

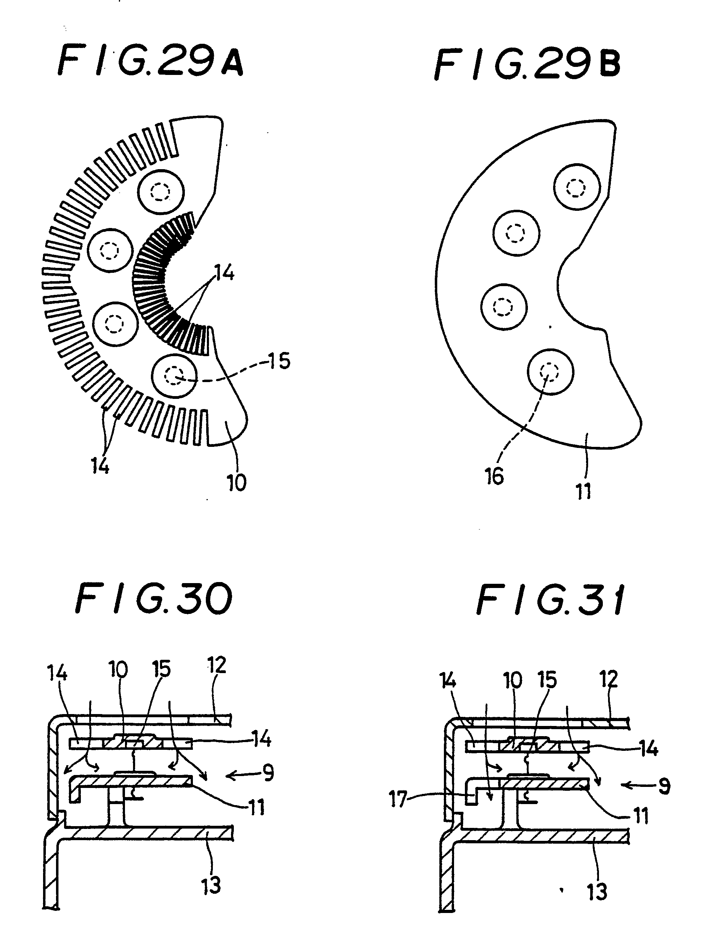

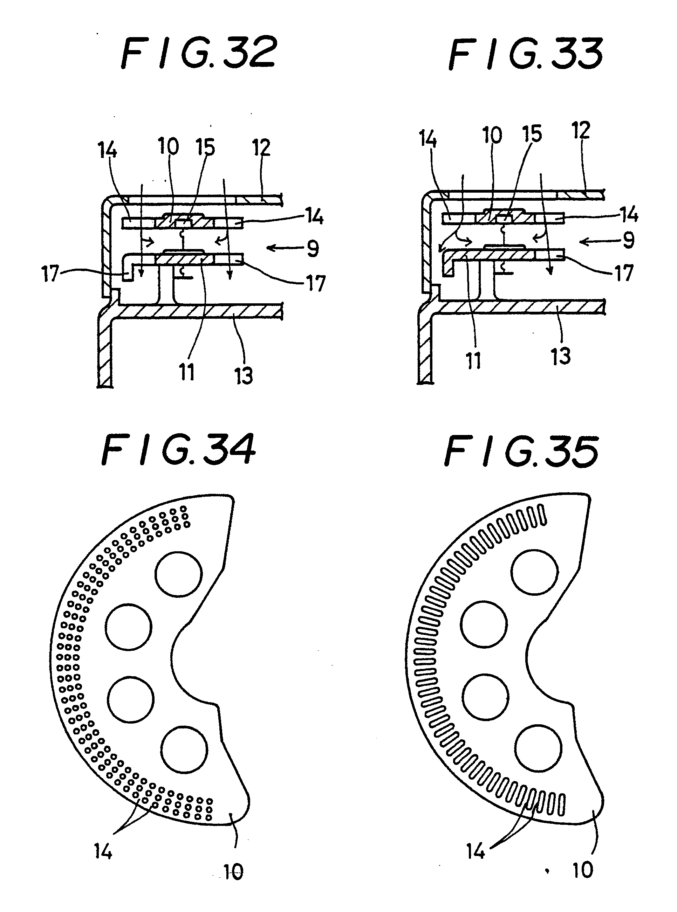

In this case, an arrangement shown in embodiments 18 to 20 of figs. 22 through 24 is practicable, wherein the inner cooling plate 11 is provided with the cooling fins 17. In accordance with embodiments 21 to 24 of figs. 25 through 28, the cooling fins 14 are not formed on the outer circumference of the outer cooling plate 10 but on the inner circumference thereof. As shown in an embodiment of figs. 29 and 30, the cooling fins 14 are formed both at the inner and outer circumferences of the outer cooling plate 10. In accordance with embodiments 26 to 28 of figs. 31 through 33, the cooling fins 17 may, of course, be shaped on both inner and outer circumferences of the inner cooling plate 11 as well as of the outer cooling plate.

In the present invention, the configuration of the cooling fins is not limited to the saw-toothed shape depicted in the foregoing embodiments. For instance, as illustrated in figs. 34 and 35, a tabular fin-forming member is punched out in an arc and preferably has slit-shaped openings, thus forming parts corresponding to the cooling fins. This arrangement exhibits an effect of preventing resonances caused at the tip parts of the fins.

In accordance with the present invention having the foregoing constructions, as discussed above, the pair of laminated cooling plates, each assuming the flat hoofed or horseshoe-like configuration and being connected to the positive and negative electrodes are cooled down by the cooling air blown from outside. The cooling air passing through the cooling fins provided on the outer cooling plate is caught at a high efficiency and then flows in between the two cooling plates. Hence the outer cooling plate is cooled down with a high efficiency in combination with the excellent cooling action by the cooling fins shaped at least on the outer circumference thereof. On the other hand, the inner cooling plate is also cooled down efficiently by synergetic action produced by catching the cooling air running through the cooling fins at the high efficiency and by disposing the diodes closer to the outer periphery than in the outer cooling plate, the diodes being turned toward the portions by which the cooling air is caught directly. As a result, the cooling efficiency can considerably be improved, thereby eliminating the necessity of designing a special cooling area, as in the prior art, by enlarging the size of the cooling plates and attaining the rectifying unit which though small both in size and in weight exhibits excellent cooling characteristics.

This arrangement that the outer diameter of the outer cooling plate is smaller than that of the inner cooling plate permits direct cooling of the outer peripheral part of the inner cooling plate fitted with the diodes by the cooling air, and also enables the cooling air to be efficiently caught by the outer peripheral part thereof. Then, the cooling flows in between the two cooling plates, and better cooling effects can be developed in the inner cooling plate as well as in the outer cooling plate. A convenient condition is thus produced. Besides, the cooling fins are formed on the inner or outer circumference of the outer cooling plate, and the diodes of the outer and inner cooling plates are disposed such that these diodes are turned in the peripheral direction. It is therefore suitable to deviate the positions in which the diodes serving as an exothermic source are attached and further effect the cooling process with high efficiency.

Moreover, the arrangement that the cooling fins are provided on the inner and outer circumferences of the outer cooling plate permits good and efficient cooling action by the cooling air with respect to the inner and outer circumferences thereof.

Although the illustrative embodiments of the present invention have been described in detail with reference to the accompanying drawings, it is to be understood that the present invention is not limited to these embodiments. A variety of modifications or changes may be effected therein by one skilled in the art without departing from the scope or spirit of the invention.

## Claims

1. A rectifying unit in a vehicle generator comprising:
a pair of metal cooling plates, each assuming a flat hoofed or horseshoe-like configuration and being insulated from each other and being connetcted to a positve and negative electrode;
diodes used for said positive electrode and disposed substantially on the same radius as that of said cooling plate of said positive electrode; and
diodes used for said negative electrode and disposed substantially on the same radius as that of said cooling plate for said negative electrode, said pair of cooling plates being laminated such that said diodes provided on said plates are located on the same side with respect to the direction of the rotor axis,
the rectifier structure comprising cooling fins which are shaped at least on an inner or outer circumference of said one cooling plate of said pair of cooling plates which is positioned outwardly of said rotor axis, and said diodes attached onto said other cooling plate positioned inwardly of said shaft core are deviated toward the outer periphery thereof from said diodes attached onto said outer cooling plate.

2. A rectifiying unit in a vehicle generator according to claim 1, characterized in that said cooling fins are shaped at least on said outer circumferences of said one cooling plate of said pair of cooling plates which is positioned outwardly of said rotor axis, said diodes attached to said other cooling plate positioned inwardly of said rotor axis are turned closer to the outer periphery thereof than said diodes attached to said outer cooling plate, and an outside diameter of said outer cooling plate is set smaller than that of said inner cooling plate.

3. A rectifying unit in a vehicle generator comprising:
a pair of metal cooling plates, each having a flat hoofed or horseshoe-like configuration and insulated from each other, for positive and negative electrodes;
diodes used for said positive electrode and disposed substantially on the same radius as that of said cooling cooling plate for said positive electrode; and
diodes used for said negative electrode and disposed substantially on the same radius as that of said cooling plate for said negative electrode, said pair of cooling plates being laminated such that said diodes provided on said plates are located on the same side with respect to the direction of the rotor axis,
a rectifier structure characterized in that cooling fins are shaped on any one of the inner and outer circumferences of said one cooling plate of said pair of cooling plates which is positions outwardly of said rotor axis, and said diodes attached to said cooling plates, respectively are disposed in the same positions in a radial direction but turned in a peripheral direction.

4. A rectifying unit in a vehicle generator according to claim 3, characterized in that said cooling fins are shaped on said inner and outer circumferences of said one cooling plate of said pair of cooling plates which is positioned outwardly of said rotor axis, and said diodes attached to said cooling plates, respectively are disposed in the same positions in the radial direction but turned in the peripheral direction.

# F I G. 1

# FIG. 2A  FIG. 2B

# FIG. 3

# FIG. 4  FIG. 5

# FIG. 6  FIG. 7

FIG. 8

FIG. 9

FIG. 10

FIG. 12

FIG. 11 A

FIG. 11 B

# F I G.13

# F I G.14

# F I G.15

# F I G.16

# F I G.17

# F I G.18

# F I G.19

EP 0 388 953 A2

FIG.20A

FIG.20B

FIG.20C

FIG.21

FIG.22

**FIG. 23**

**FIG. 24**

**FIG. 25**

**FIG. 26**

**FIG. 27**

**FIG. 28**

# F I G.29 A

# F I G.29 B

# F I G.30

# F I G.31

# F I G. 32

# F I G. 33

# F I G. 34

# F I G. 35